**Europäisches Patentamt**

**European Patent Office**

**Office européen des brevets**

(11) Veröffentlichungsnummer: **0 166 105 B1**

# EUROPÄISCHE PATENTSCHRIFT

(45) Veröffentlichungstag der Patentschrift:
**08.02.89**

(51) Int. Cl.⁴: **H 05 K 1/00, H 05 K 3/10**

(21) Anmeldenummer: **85104729.0**

(22) Anmeldetag: **18.04.85**

(54) **Flexible Leiterplatte und Verfahren zu ihrer Herstellung.**

(30) Priorität: **27.06.84 JP 132253/84**

(43) Veröffentlichungstag der Anmeldung:
**02.01.86 Patentblatt 86/1**

(45) Bekanntmachung des Hinweises auf die Patenterteilung:
**08.02.89 Patentblatt 89/6**

(84) Benannte Vertragsstaaten:
**AT BE CH DE FR GB IT LI NL SE**

(56) Entgegenhaltungen:
**GB-A- 1 098 182**
**JP-A-57 079 697**

(73) Patentinhaber: **NIPPON MEKTRON, LTD.,**
**12-15, 1-Chome Shiba Daimon, Minato-ku Tokyo (JP)**

(72) Erfinder: **Mizuko, Tutomu, 1343-49 Arakawa-Hongo**
**Ami-machi, Inashiki-gun Ibaragi-ken 300-11 (JP)**
Erfinder: **Tsukahara, Toshiyuki, 2210-4 Arakawa-hongo**
**Ami-machi, Inashiki-gun Ibaragi-ken 300-11 (JP)**
Erfinder: **Yoshida, Masahiro, 5403-5 Omigawa**
**Omigawa-machi, Katori-gun Chiba-ken 289-03 (JP)**
Erfinder: **Nemoto, Koji, 5457-1 Hiraiso-machi,**
**Nakaminato-shi Ibaragi-ken 311-12 (JP)**

(74) Vertreter: **Weissenfeld-Richters, Helga, Dr.,**
**Höhnerweg 2, D-6940 Weinheim/Bergstrasse (DE)**

## Beschreibung

Die Erfindung betrifft eine flexible Leiterplatte mit einem Bereich zum Einbau elektronischer Bauelemente und mit einem sich daran anschliessenden Bereich ohne Einbaumöglichkeit sowie ein Verfahren zu ihrer Herstellung.

Flexible Leiterplatten dieser Art finden vielseitig als Verdrahtungsmittel für die verschiedensten elektrischen und elektronischen Geräte Anwendung. Zur Herstellung einer solchen flexiblen Leiterplatte wird zunächst ein geeignetes flexibles, isolierendes Basismaterial beidseitig mit einer leitenden Folie aus Metall, vorzugsweise Kupfer, kaschiert. Das kaschierte Basismaterial wird an gewünschter Stelle mit Kontaktbohrungen versehen. Durch chemische Metallisierung der gesamten Folie werden die Bohrungen innenseitig elektrisch leitfähig ausgerüstet. Um eine sichere Durchkontaktierung zu gewährleisten, wird die Oberfläche zusätzlich elektroplattiert. Anschliessend werden die gewünschten Schaltungsbilder beidseitig durch Ätzung erzeugt, während auf dem daran anschliessenden Bereich ohne Einbaumöglichkeit ein- bzw. beidseitig ein anderes Schaltungsbild zugleich hergestellt werden kann.

Dieses bekannte Verfahren birgt das erhebliche Problem in sich, dass der chemische Überzug, der sich über die Fläche der Bereiche mit und ohne Einbaumöglichkeit erstreckt, infolge seiner mangelnden Flexibilität den Bereich ohne Einbaumöglichkeit zu sehr versteift, so dass es bei stärkerer Biegung zum Leiterbruch im entsprechenden Bereich kommen kann.

Um das erwähnte Problem zu lösen, sind z.B. aus JP-GM-AS 56-54 607 und JP-P-OS 57-79 697 Verfahren bekannt, bei denen der Bereich ohne Einbaumöglichkeit nur einseitig mit einem Schaltungsbild versehen ist, auf welchem sich überhaupt keine Plattierungsschicht befindet, damit dessen Biegsamkeit erhalten und damit ein Leiterbruch ausgeschlossen werden kann.

Ist der zum Einbau von Bauelementen vorgesehene Bereich mit einer Elektroplattierungsschicht überzogen, während der andere Bereich nur mit einer leitenden Folie kaschiert ist, so entsteht im Grenzgebiet zwischen beiden Bereichen eine Abstufung. Im unmittelbar dieser Abstufung benachbarten Bereich sind präzise Fotoresist- und Ätzverfahren nur schwer durchführbar. Darüber hinaus stellt die Abstufung eine weitere Ursache für einen möglichen Leiterbruch infolge von mechanischen Spannungen dar. Um andererseits lediglich den Bereich mit Einbaumöglichkeit einer chemischen Metallisierung sowie einer Elektroplattierung unterziehen zu können, ist gegenüber dem anderen Bereich eine Maskierung erforderlich, was einen hohen Arbeitsaufwand und ein späteres, oft umständliches Entfernen der Maske erfordert.

Ausgehend von einer flexiblen Leiterplatte der genannten Art mit einem ersten Bereich, der beidseitig jeweils mit Leiterbahnen gemäss Schaltungsbildern versehen ist, und einem mit diesem Bereich verbundenen Bereich, der Leiterbahnen ohne Elektroplattierungsschicht aufweist, welche mit den Leiterbahnen im ersten Bereich elektrisch verbunden sind, liegt die Aufgabe der vorliegenden Erfindung darin, die genannten Nachteile bezüglich der Bruchgefahr sowie des komplizierten Herstellungsverfahrens durch Schaffung einer neuen Leiterplatte zu umgehen.

Ferner soll ein geeignetes neues Verfahren zur Herstellung einer solchen Leiterplatte angegeben werden.

Die Lösung dieser Aufgabe besteht darin, dass sich zwischen dem ersten Bereich und dem zweiten Bereich ein Übergangsbereich befindet, in dem die Stärke der elektroplattierten Schicht kontinuierlich abnimmt.

Die Erfindung legt ferner ein Verfahren zur Herstellung einer solchen flexiblen Leiterplatte dar, bei dem zunächst ein flexibles, isolierendes Basismaterial beidseitig mit einer leitenden Folie kaschiert und mit Bohrungen versehen wird. Danach erfolgt eine chemische Metallisierung der Innenwandung der Bohrungen sowie der leitenden Folie. Es schliesst sich ein Ätzvorgang an, bei dem die Leiterplatte zu einem ersten Bereich mit Leiterbahnen gemäss Schaltungsbildern verarbeitet wird, wobei sich an den ersten Bereich ein zweiter Bereich mit einem anderen Schaltungsbild anschliesst, welches beim Ätzvorgang zusammen mit wenigstens einem der benachbarten Schaltungsbilder hergestellt wird. Eine Abschirmplatte wird auf den zweiten Bereich aufgelegt, die so ausgebildet ist, dass in einem Übergangsbereich zwischen dem ersten und zweiten Bereich der Leiterplatte ein Zwischenraum zwischen der Abschirmplatte und der chemisch aufgebrachten Schicht bestehen bleibt.

Die chemisch abgeschiedene Schicht im ersten Bereich wird durch Elektroplattieren mit einer weiteren Schicht überzogen und gleichzeitig eine Schicht aus gleichem Material im Übergangsbereich erzeugt, deren Stärke vom ersten zum zweiten Bereich kontinuierlich abnimmt.

Auf diese Weise ist es möglich, die Elektroplattierungen für den ersten Bereich und die durchkontaktierten Bohrungen sowie für den Übergangsbereich unter Verwendung der Abschirmplatte gleichzeitig durchzuführen.

Es kann aber auch von Vorteil sein, das Elektroplattierverfahren als gesonderten Arbeitsgang bereits vor dem Ätzen vorzunehmen.

Die Leiterbahnen, die sich im Übergangsbereich befinden, sind also mit einer elektroplattierten Schicht versehen, die in die chemisch abgeschiedene Metallschicht auf den Leiterbahnen des Schaltungsteils kontinuierlich übergeht. Damit ist an jeder Stelle der Leiterplatte die einwandfreie Erzeugung eines Schaltungsbildes möglich. Ferner besteht keine durch eine Abstufung bedingte Gefahr eines Leiterbruchs mehr.

Die Erfindung wird anhand der Figuren weiter verdeutlicht.

Dabei stellen im Querschnitt

Figur 1 schematisch einen Teil der erfindungsgemässen flexiblen Leiterplatte und

Figuren 2 und 3 jeweils die Ausbildung und Anbringung einer beim erfindungsgemässen Verfahren verwendeten Abschirmplatte dar.

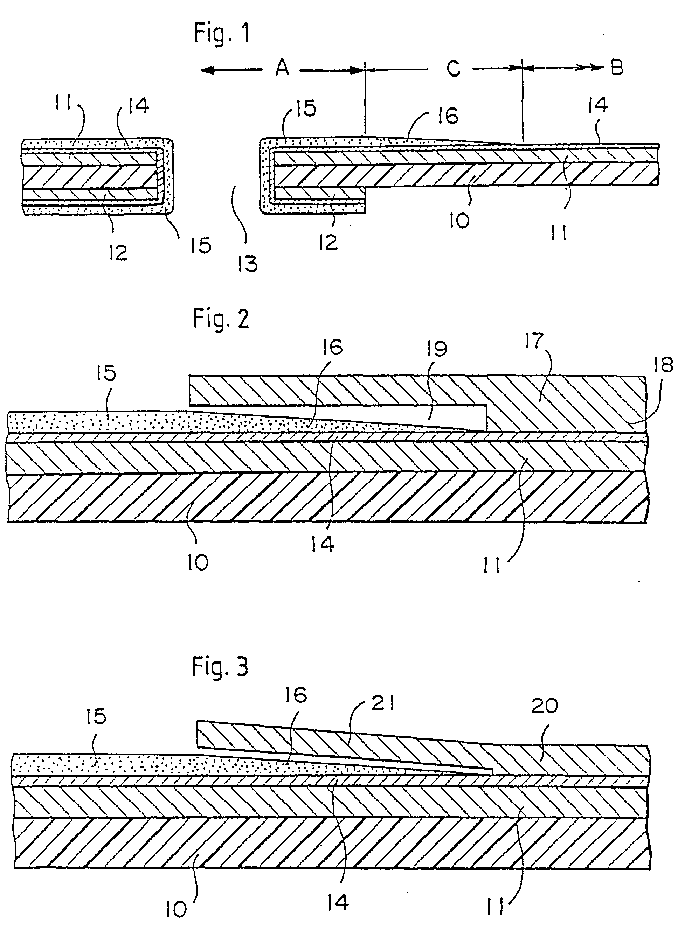

Figur 1 nimmt Bezug auf eine flexible Leiterplatte mit einem flexiblen Basismaterial 10 aus einem Kunststoffilm, wie z.B. Polyamid oder Polyimid. Auf einer Seite des Basismaterials 10 befindet sich das obere Schaltungsbild 11 aus leitender Metallfolie, vorzugsweise Kupfer, auf der anderen Seite das untere Schaltungsbild 12. Auf den mit diesem Schaltungsbild 12 versehenen Bereich A folgt ein Übergangsbereich C gemäss der Erfindung, woran sich ein Bereich B anschliesst. Im Abschnitt A ist eine durchkontaktierte Bohrung 13 für den elektrischen Anschluss von elektronischen Bauelementen dargestellt. Auf der gesamten Fläche der Schaltungsbilder 11 und 12 ist eine Metallschicht 14, vorzugsweise Kupfer, chemisch abgeschieden, wodurch auch der Innenumfang der Bohrung 13 leitend ist. Diese Schicht 14 ist üblicherweise mindestens 200 nm dick. Ein elektroplattierter Überzug 15 befindet sich auf Abschnitt A und C sowie auf dem unteren Schaltungsbild 12 und im Innenumfang der Bohrung 13. Dieser Überzug 15 endet in einer Zone 16 im Übergangsbereich C. Er fehlt jedoch auf dem Schaltungsbild 11 im Bereich des Abschnitts B. Somit zeichnet sich der Abschnitt B durch gute Biegsamkeit aus, da sein Leiterbild 11 lediglich mit der chemisch abgeschiedenen Schicht 14 überzogen ist und keinen elektroplattierten Überzug harter Struktur besitzt. Der Übergangsbereich C mit der Zone 16 bringt den Vorteil, dass die mechanische Spannungskonzentration bei Biegung entsprechend herabgesetzt und damit ein möglicher Leiterbruch des Schaltungsbildes 11 vermieden wird.

Zur Herstellung einer solchen flexiblen Leiterplatte wird das Basismaterial 10 beidseitig mit einer leitenden Folie kaschiert. Abschnitt A wird sodann mit einer Durchgangsbohrung 13 versehen, und in an sich bekannter Weise folgt die chemische Metallisierung der Innenwandung der Bohrung sowie der gesamten Fläche der leitenden Folie unter Bildung einer Schicht 14 mit einer Dicke von mindestens 200 nm. Wie in Figur 2 bzw. 3 gezeigt, wird dann erfindungsgemäss eine Abschirmplatte 17 bzw. 20 im gewünschten Bereich des Abschnitts B angebracht, um dadurch lediglich die Bereiche A und C zu elektroplattieren; es entsteht somit die Plattierungsschicht 15 mit der Übergangszone 16. Danach werden die Abschirmplatte entfernt und Fotoresist- sowie Ätzvorgänge zur Erzeugung der Schaltungsbilder 11 und 12 vorgenommen.

Anstelle dieses Verfahrens besteht auch die Möglichkeit, unmittelbar nach der chemischen Metallisierung die Fotoresist- und Ätzvorgänge und danach die Elektroplattierung durchzuführen, wobei wiederum erfindungsgemäss die Abschirmplatte 17 bzw. 20 im Bereich B angebracht wird. Mit dieser Verfahrensvariante sind der elektroplattierte Überzug 15 und die Übergangszone 16 auf die Schaltungsbilder 11 im Bereich A und C sowie auf die Innenseite der Bohrung 13 gleichzeitig aufbringbar.

Gemäss der Figur 2 weist die Abschirmplatte 17 einen Teil 18 auf, der auf der Schicht 14 im Abschnitt B aufliegt. Die Platte 17 ist derart ausgebildet, dass ein Zwischenraum 19 zur Schicht 14 im Übergangsbereich C vorhanden ist.

In diesem Zwischenraum 19 wird die Übergangszone 16 im Bereich C gebildet. Zur noch vorteilhafteren Herstellung des kontinuierlichen Übergangs 16 ist alternativ eine Abschirmplatte 20 (Figur 3) mit einem in Richtung zum Bereich A aufwärts gewinkelten Teil 21 verwendbar. Mit Hilfe einer solchen Abschirmplatte 20 ist eine beliebige Variation der Neigung durch unterschiedliche Winkel des Teils 21 möglich. Besitzt z.B. der elektroplattierte Überzug 15 eine Dicke von 1200 nm, so beträgt der erforderliche Winkel des Teils 21 etwa 20°.

Die Abschirmplatte 17 bzw. 20 kann auf dem Bereich B entweder mittels einer Klemme oder durch leichtes Ankleben befestigt werden. Sie ist jedenfalls so zu befestigen, dass ein leichtes Entfernen nach dem Elektroplattieren möglich ist.

In den Figuren ist der Bereich B nur einseitig mit einem Schaltungsbild versehen. Selbstverständlich ist auch eine Version mit auf beiden Seiten befindlichen Schaltungsmustern denkbar und möglich.

In jedem Falle bewirkt die Erfindung eine Vermeidung von mechanischen Spannungskonzentrationen und damit der Gefahr eines Leiterbruchs. Ferner erhält man ein Erzeugnis mit hoher Flexibilität.

**Patentansprüche**

1. Flexible Leiterplatte mit einem ersten Bereich (A), der beidseitig mit Leiterbahnen versehen ist und durchkontaktierte Bohrungen (13) aufweist, wobei die Leiterbahnen und die Bohrungen mit einer elektroplattierten Schicht (15) überzogen sind, sowie mit einem zweiten Bereich (B), dessen Leiterbahnen frei von der elektroplattierten Schicht sind, so dass der zweite Bereich (B) flexibler als der erste Bereich (A) ist, dadurch gekennzeichnet, dass sich zwischen dem ersten Bereich (A) und dem zweiten Bereich (B) ein Übergangsbereich (C) befindet, in dem die Stärke der elektroplattierten Schicht (16) kontinuierlich abnimmt.

2. Verfahren zur Herstellung einer flexiblen Leiterplatte, das die folgenden Schritte aufweist:

Ein flexibles isolierendes Basismaterial (10) wird beidseitig mit einer leitenden Folie (11, 12) kaschiert und mit Bohrungen (13) versehen;

es erfolgt eine chemische Metallisierung der Innenwandung der Bohrungen sowie der leitenden Folie;

es schliesst sich ein Ätzvorgang an, bei dem die Leiterplatte zu einem ersten Bereich (A) mit Leiterbahnen gemäss Schaltungsbildern verarbeitet wird, wobei sich an den ersten Bereich (A) ein zweiter Bereich (B) mit einem anderen Schaltungsbild anschliesst, welches beim Ätzvorgang zusammen mit wenigstens einem der benachbarten Schaltungsbilder hergestellt wird;

eine Abschirmplatte (17, 20) wird auf den zweiten Bereich (B) aufgelegt, die so ausgebildet ist, dass in einem Übergangsbereich (C) zwischen dem ersten und zweiten Bereich der Leiterplatte ein Zwischenraum (19) zwischen der Abschirmplatte und der chemisch aufgebrachten Schicht (14) bestehen bleibt;

die chemisch abgeschiedene Schicht (14) im ersten Bereich (A) wird durch Elektroplattieren mit einer weiteren Schicht (15) überzogen und gleichzeitig eine Schicht (16) aus gleichem Material im Übergangsbereich (C) erzeugt, deren Stärke vom ersten zum zweiten Bereich kontinuierlich abnimmt.

3. Verfahren nach Anspruch 2, dadurch gekennzeichnet, dass die Elektroplattierung als gesonderter Arbeitsgang vor dem Ätzen erfolgt.

4. Verfahren nach Anspruch 2 oder 3, dadurch gekennzeichnet, dass zur Ausbildung des Zwischenraumes (19) die Abschirmplatte (20) im Übergangsbereich (C) einen von der Leiterplatte abgewinkelten, in Richtung auf den ersten Bereich (A) zeigenden Teil (21) besitzt.

**Revendications**

1. Plaquette conductrice flexible avec une première zone (A) qui est pourvue, sur les deux faces, de pistes conductrices et qui présente des perforations de contact de part en part (13), tandis que les pistes conductrices et les perforations sont revêtues d'une couche (15) déposée par électro-déposition, ainsi qu'avec une seconde zone (B) dont les pistes conductrices sont indépendantes de la couche déposée par électro-déposition si bien que la seconde zone (B) est plus flexible que la première zone (A), caractérisée en ce qu'une zone de transition (C) se trouve entre la première zone (A) et la seconde zone (B), et que l'épaisseur de la couche (16) déposée par électro-déposition y diminue de manière continue.

2. Procédé de production d'une plaquette conductrice flexible qui comporte les phases suivantes:

Un matériau de base isolant flexible (10) est revêtu sur les deux faces d'une feuille conductrice (11, 12) et est pourvu de perforations (13);

on effectue ensuite une métallisation chimique de la paroi intérieure des perforations ainsi que des feuilles conductrices;

on réalise ensuite une opération de décapage qui crée des tracés de circuits constitués de pistes conductrices dans une première zone (A) de la plaquette conductrice, tandis qu'une seconde zone (B), avec un autre tracé de circuit, se raccorde à la première zone (A), cette zone étant réalisée en même temps qu'au moins l'un des tracés de circuits voisins;

une plaque de protection (17, 20) est appliquée sur la seconde zone (B) et est constituée de façon à ce qu'il reste, dans une zone de transition (C) entre la première et la seconde zone de la plaquette conductrice, un espace intermédiaire (19) entre la plaque de protection et la couche (14) appliquée par voie chimique;

la couche déposée chimiquement (14) dans la première zone (A) est revêtue, par électro-déposition, d'une autre couche (15) et une couche (16) du même matériau est créée simultanément dans la zone de transition (C), tandis que son épaisseur diminue de manière continue de la première zone à la seconde zone.

3. Procédé selon la revendication 2, caractérisé en ce que lélectro-déposition est réalisée comme opération séparée, avant le décapage.

4. Procédé selon la revendication 2 ou 3, caractérisé en ce que, pour créer l'espace intermédiaire (19), la plaque de protection (20) possède, dans la zone de transition (C), une partie pliée (21) s'écartant de la plaquette conductrice en direction de la première zone (A).

**Claims**

1. Flexible circuit board having a first region (A), which is provided on both sides with conductor tracks and has plated-through holes (13), the conductor tracks and the holes being coated with an electroplated layer (15), as well as having a second region (B), the conductor tracks of which are free from the electroplated layer, so that the second region (B) is more flexible than the first region (A), characterised in that between the first region (A) and the second region (B) there is a junction region (C), in which the thickness of the electroplated layer decreases continuously.

2. Method of producing a flexible circuit board which has the following steps:

a flexible insulating base material (10) is laminated on both sides with a conductive foil (11, 12) and is provided with holes (13);

a chemical metallization of the inner wall of the holes and of the conductive foil is performed;

an etching operation follows, in which the circuit board is processed to give a first region (A) with conductor tracks according to circuit designs, the first region (A) being adjoined by a second region (B) having a different circuit design, which is produced during the etching operation together with at least one of the neighbouring circuit designs;

a screening plate (17, 20) is laid on the second region (B), which screening plate is designed such that an intermediate space (19) remains between the said plate and the chemically applied layer (14) in a junction region (C) between the first and second regions of the circuit board;

the chemically deposited layer (14) in the first region (A) is coated by electroplating with a further layer (15) and at the same time a layer (16) of the same material il produced in the junction region (C), the thickness of the latter layer decreasing continuously from the first to the second region.

3. Method according to claim 2, characterised in that the electroplating is performed as a separate operation before the etching.

4. Method according to either of claims 2 or 3, characterised in that, to form the intermediate space (19), the screening plate (20) has in the junction region (C) a part (21) which is angled off from the circuit board and points in the direction of the first region (A).

$I/I$

Fig. 1

A ← → | C | → B

11  14  15  16  14

15  12  15  13  12  10  11

Fig. 2

15  16  19  17  18

10  14  11

Fig. 3

15  16  21  20

10  14  11